**Europäisches Patentamt**

**European Patent Office**

**Office européen des brevets**

(11) Veröffentlichungsnummer : **0 306 748 B1**

(12) **EUROPÄISCHE PATENTSCHRIFT**

(45) Veröffentlichungstag der Patentschrift :
**12.06.91 Patentblatt 91/24**

(51) Int. Cl.⁵ : **H05K 13/04, B23K 3/04**

(21) Anmeldenummer : **88113515.6**

(22) Anmeldetag : **19.08.88**

(54) **Lötvorrichtung.**

(30) Priorität : **11.09.87 DE 3730648**

(43) Veröffentlichungstag der Anmeldung :
**15.03.89 Patentblatt 89/11**

(45) Bekanntmachung des Hinweises auf die
Patenterteilung :
**12.06.91 Patentblatt 91/24**

(84) Benannte Vertragsstaaten :
**AT BE CH DE FR GB IT LI NL SE**

(56) Entgegenhaltungen :
**DE-A- 3 149 236**
**FR-A- 2 388 626**

(73) Patentinhaber : **Siemens Aktiengesellschaft**
**Wittelsbacherplatz 2**
**W-8000 München 2 (DE)**

(72) Erfinder : **Hillebrand, Bernhard**
**Schanzenbachstrasse 10**
**W-8000 München 70 (DE)**

EP 0 306 748 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patent-übereinkommen).

Jouve, 18, rue Saint-Denis, 75001 PARIS

## Beschreibung

Die Erfindung betrifft eine Lötvorrichtung mit einem Lötbügelhalter und mindestens einem am Lötbügelhalter auswechselbar befestigten Flachlötbügel, wobei zwei äußere Schenkel des Flachlötbügels mit dem einen Pol einer Stromquelle verbindbar sind und wobei ein mittlerer Schenkel des Flachlötbügels mit dem anderen Pol der Stromquelle verbindbar ist.

Aus der DE-A-31 49 236 ist eine Schweißvorrichtung bekannt, die einen Körper aufweist, der aus kleinen Säulen aus leitfähigem Material ausgebildet ist, zwischen deren Enden in auswechselbarer Weise mindestens zwei Bügelelektroden befestigt sind. Die U-förmigen Bügelelektroden, die aufgrund des Joule-Effektes erhitzt werden können, sind aus einer ebenen Platte hergestellt und in der Weise angebracht, daß sie mit ihrem randseitigen Schweißsteg in Kontakt mit den zu verschweißenden Elementen kommen. Bei einer Anzahl von zwei oder vier Bügelelektroden werden insgesamt vier kleine Säulen benötigt, die auf einer jeweiligen Diagonale der Schweißvorrichtung angeordnet sind und durch mehrere kreuzförmige Verstrebungen miteinander verbunden sind.

Die bekannte Schweißvorrichtung und ähnlich aufgebaute Lötvorrichtungen werden für das Reflow-Löten hochpoliger Bauteile, insbesondere von SMD-Bauteilen wie Flatpack, Mikropack und dergleichen eingesetzt. Dabei wird die Vorrichtung derart abgesenkt, daß die jeweiligen Anschlüsse des Bauteils durch die Bügelelektrode mit den Enden der Leiterbahnen einer Leiterplatte oder eines Keramiksubstrats in Kontakt gehalten werden. Danach werden die Bügelelektroden mit Strom hoher Intensität gespeist, so daß die abgegebene Wärme die angestrebte Schweiß-oder Lötverbindung bewirkt. Nach Verfestigung des aufgeschmolzenen Materials wird die gesamte Vorrichtung dann wieder angehoben.

Es sind auch Lötvorrichtungen der eingangs genannten Art bekannt, die anstelle U-förmiger Bügelelektroden sogenannte Flachlötbügel mit einer Mittelzuführung besitzen. Dabei sind jeweils zwei äußere Schenkel des E-förmigen Flachlötbügels mit dem einen Pol einer Stromquelle verbunden, während der mittlere Schenkel des Flachlötbügels mit dem anderen Pol der Stromquelle verbunden ist. Die Mittelzuführung bewirkt hierbei eine Halbierung der Spannung die dem Flachlötbügel zugeführt wird. Andererseits weist jedoch die E-förmige Lötbügelausbildung mit drei Anschlüssen eine geringe mechanische Stabilität auf, wobei es zusätzlich auch noch durch unterschiedliche Übergangswiderstände zwischen den Anschlüssen und den zugeordneten Kontaktflächen des Lötbügelhalters zu einer ungleichmäßigen Wärmeverteilung im Bereich des der Lötstelle zugewandten Lötsteges kommen kann.

Der Erfindung liegt die Aufgabe zugrunde, bei einer gattungsgemäßen Lötvorrichtung die mechanische Stabilität des Flachlötbügels und die Wärmeverteilung im Bereich des Lötsteges zu verbessern.

Diese Aufgabe wird erfindungsgemäß dadurch gelöst, daß der einstückig aus einer ebenen Platte herausgebildete Flachlötbügel durch einen sich zwischen den äußeren Schenkeln erstreckenden Quersteg eine geschlossene Form aufweist.

Der Erfindung liegt die Erkenntnis zugrunde, daß durch die einstückige geschlossene Bauform der Flachlötbügel einerseits deren Eigenstabilität beträchtlich erhöht wird und andererseits die Reduzierung auf eine Kontaktstelle im Bereich des Quersteges und eine Kontaktstelle im Bereich des mittleren Schenkels zu einer stets gleichmäßigen Stromverteilung und damit zu einer gleichmäßigen Wärmeverteilung im Bereich des Lötsteges führt.

Gemäß einer bevorzugten Ausgestaltung der Erfindung sind die beiden äußeren Schenkel und der mittlere Schenkel zum Quersteg hin verbreitert ausgebildet. Hierdurch wird die Stromzuführung im äußeren Bereich und genau im mittleren Bereich des Lötsteges über entsprechend schmale Stege der äußeren Schenkel und des mittleren Schenkels erleichtert.

Gemäß einer weiteren bevorzugten Ausgestaltung der Erfindung sind die beiden äußeren Schenkel und der Quersteg einerseits und der mittlere Schenkel andererseits durch einen Schlitz getrennt. Dieser dann vorzugsweise zum Lötsteg des Flachlötbügels hin verbreiterte Schlitz ermöglicht eine besonders kompakte und besonders stabile Form des Flachlötbügels, wobei diese Vorteile durch einen erodierten Schlitz nochmals verstärkt werden können.

Eine besonders kompakte Bauweise der Lötvorrichtung kann dadurch erzielt werden, daß der Lötbügelhalter aus einem Mittelteil und einem ringförmig geschlossenen, elektrisch isoliert und formschlüssig auf dem Mittelteil angeordneten Außenteil besteht, wobei Quersteg und mittlerer Schenkel des Flachlötbügels lösbar mit zugeordneten Kontaktflächen von Außenteil und Mittelteil verbunden sind. Der Lötbügelhalter besteht dann für einen Flachlötbügel und auch für mehrere Flachlötbügel nur noch aus zwei Teilen, über die dann auch die Stromversorgung vorgenommen wird.

Weisen Mittelteil und Außenteil zumindest im Bereich der Kontaktflächen die gleiche Außenkontur auf, so wird hierdurch die Anbringung der Flachlötbügel weiter erleichtert. Im Hinblick auf die üblichen Bauformen der aufzulötenden elektronischen Bauteile wird zweckmäßigerweise von einer rechteckförmigen oder quadratischen Außenkontur ausgegangen, die zudem die einfache Anbringung der Flachlötbügel weiter begünstigt. Eine weitere Abstimmung auf diese Bauformen der Bauteile bei gleichzeitiger Erhöhung der mechanischen Stabilität führt dann zu einer rechteckförmigen oder quadratischen Außenkontur des Mittelteils und einer rechteckförmigen oder quadratischen Innenkontur des Außenteils im Bereich des Formschlusses.

Schließlich hat es sich im Hinblick auf die angestrebte hohe Stabilität und die kompakte Bauweise des Lötbügelhalters als vorteilhaft erwiesen, wenn Mittelteil und Außenteil durch einen isolierenden Zweikomponenten-Klebstoff miteinander verbunden sind.

Ein Ausführungsbeispiel der Erfindung ist in der Zeichnung dargestellt und wird im folgenden näher beschrieben.

Es zeigen

Fig. 1 das stark vereinfachte Grundprinzip eines erfindungsgemäßen Flachlötbügels,

Fig. 2 eine Seitenansicht einer Lötvorrichtung mit zwei erfindungsgemäßen Flachlötbügeln und

Fig. 3 einen Schnitt durch Lötbügelhalter und Flachlötbügel der in Fig. 2 dargestellten Lötvorrichtung.

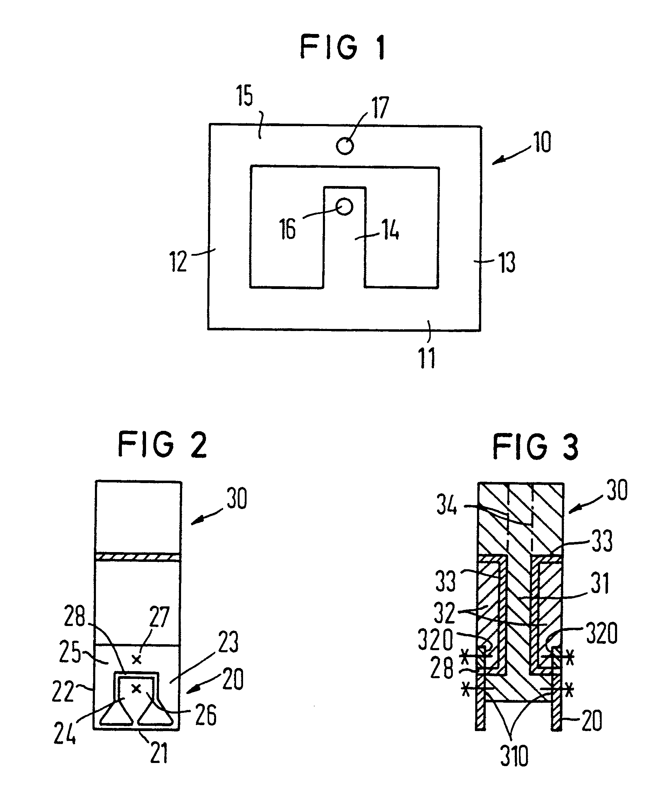

Fig. 1 zeigt in stark vereinfachter schematischer Darstellung das Grundprinzip eines erfindungsgemäß ausgestalteten Flachlötbügels 10, dessen Lötsteg mit 11, dessen zwei äußere Schenkel mit 12 und 13 und dessen mittlerer Schenkel mit 14 bezeichnet sind. Durch einen sich zwischen den Enden der äußeren Schenkel 12 und 13 erstreckenden Quersteg 15 erhält der einstückig aus einer ebenen Platte herausgebildete Flachlötbügel 10 eine geschlossene Form, die zu einer sehr hohen Eigenstabilität führt.

Die geschlossene Form erfordert dann nur noch zwei Kontaktstellen, deren Lage durch eine in den mittleren Schenkel 14 eingebrachte Bohrung 16 und durch einen mittig in den Quersteg 15 eingebrachte Bohrung 17 aufgezeigt ist. Die Kontaktierung und die Befestigung dieses Flachlötbügels 10 an einem Lötbügelhalter erfolgt dann durch in die Bohrungen 16 und 17 eingesetzte Schrauben. Auch bei unterschiedlichen Übergangswiderständen der Kontaktierungen wird eine gleichmäßige Stromund Wärmeverteilung im Bereich des Lötsteges 11 erzielt.

Die Fig. 2 und 3 zeigen eine Lötvorrichtung mit zwei parallelen und im Abstand zueinander an einem Lötbügelhalter 30 befestigten Flachlötbügeln 20. Jeder dieser Flachlötbügel 20 besteht aus einem Lötsteg 21, zwei äußeren Schenkeln 22 und 23, einem mittleren Schenkel 24 und einem sich zwischen den äußeren Schenkeln 22 und 23 erstreckenden Quersteg 25, wobei die Befestigung und Kontaktierung des mittleren Schenkels 24 und des Querstegs 25 durch lediglich schematisch angedeutete Schrauben 26 bzw. 27 vorgenommen ist. Jeder der Flachlötbügel 20 ist aus einer ebenen Platte herausgebildet, in welche zur Trennung der beiden äußeren Schenkel 22 und 23 sowie des Querstegs 25 einerseits und des mittleren Schenkels 24 andererseits ein Schlitz 28 durch Drahterosion angebracht ist. Der Schlitz 28 besitzt dabei eine U-förmige Gestalt, wobei sich die freien Schenkel dieses U-förmigen Schlitzes 28 zum Lötsteg 21 hin derart dreiecksförmig verbreitern, daß sich eine entsprechende Verbreiterung der beiden äußeren Schenkel 22 und 23 und des mittleren Schenkels 24 zum Quersteg 25 hin ergibt.

Der Lötbügelhalter 30 besteht aus einem Mittelteil 31 und einem ringförmig geschlossenen und durch einen isolierenden Zweikomponenten-Klebstoff 33 elektrisch getrennt auf dem Mittelteil 31 angeordneten Außenteil 32. Der Mittelteil 31 besitzt einen quadratischen Querschnitt, dessen mittlerer Bereich derart bemessen ist, daß der hier formschlüssig aufgesetzte Außenteil 32 die gleiche Außenkontur aufweisen kann wie die übrigen Bereiche des Mittelteils 31. Durch zwei strichpunktierte Linien 34 ist angedeutet, daß der Mittelteil 31 ursprünglich aus zwei Teilen besteht, die nach dem Aufbringen des Außenteils 32 und vor dem Einbringen des Zweikomponenten-Klebstoffs 33 beispielsweise durch Löten miteinander verbunden werden.

Der aus dem Mittelteil 31, dem Außenteil 32 und der durch den Zweikomponenten-Klebstoff 33 gebildeten dünnen Isolier- und Verbindungsschicht bestehende Lötbügelhalter 30 besitzt im Bereich des unteren Endes des Mittelteils 31 zwei gegenüberliegende Kontaktflächen 310 und zwei plan dazu ausgerichtete, einander gegenüberliegende Kontaktflächen 320 im Bereich des Außenteils 32. Die Verbindung der Querstege 25 der Flachlötbügel 20 mit den Kontaktflächen 320 erfolgt durch die bereits erwähnten Schrauben 27 während die Verbindung der mittleren Schenkel 24 der Flachlötbügel 20 mit den Kontaktflächen 310 durch die ebenfalls bereits erwähnten Schrauben 26 erfolgt. Der Mittelteil 31 ist dabei im unteren Bereich an den Ecken derart abgeschrägt, daß die Breite der Kontaktflächen 310 der Breite der mittleren Schenkel 24 entspricht.

Als Materialien für den Mittelteil 31 und den Außenteil 32 sind beispielsweise hochfeste Kupferlegierungen geeignet, während als Materialien für die Flachlötbügel 20 beispielsweise Widerstandsmaterialien wie Molybdän oder Titan geeignet sind.

Bei der anhand den Fig. 2 und 3 beschriebenen Lötvorrichtung werden zwei parallel im Abstand zueinander ausgerichtete Flachlötbügel 20 eingesetzt, die zum Einlöten von Bauteilen mit zwei parallelen Reihen von Anschlüssen geeignet sind. Es ist zu erkennen, daß an dem Lötbügelhalter ohne weiteres auch vier Flachlötbügel angebracht werden können und daß selbst auch Ausführungsformen mit mehr als vier Lötbügeln möglich sind. Bei einem sechseckförmigen Querschnitt des Lötbügelhalters können beispielsweise sechs Flachlötbügel eingesetzt werden. Unabhängig von der Anzahl der am Lötbügelhalter angebrachten Flachlötbügel sind in jedem Fall nur noch zwei Stromzuführungen zum Lötbügelhalter erforderlich. Diese Stromzuführungen werden beispielsweise auf einfache Weise am Außenteil und am Mittelteil mittels Schrauben befestigt.

## Ansprüche

1. Lötvorrichtung mit einem Lötbügelhalter und mindestens einem am Lötbügelhalter auswechselbar befestigten Flachlötbügel, wobei zwei äußere Schenkel des Flachlötbügels mit dem einen Pol einer Stromquelle verbindbar sind und wobei ein mittlerer Schenkel des Flachlötbügels mit dem anderen Pol der Stromquelle verbindbar ist, **dadurch gekennzeichnet,** daß der einstückig aus einer ebenen Platte herausgebildete Flachlötbügel (10 ; 20) durch einen sich zwischen den äußeren Schenkeln (12, 13 ; 22, 23) erstreckenden Quersteg (15 ; 25) eine geschlossene Form aufweist.

2. Lötvorrichtung nach Anspruch 1, **dadurch gekennzeichnet,** daß die beiden äußeren Schenkel (22, 23) und der mittlere Schenkel (24) zum Quersteg (25) hin verbreitert ausgebildet sind.

3. Lötvorrichtung nach Anspruch 1 oder 2, **dadurch gekennzeichnet,** daß die beiden äußeren Schenkel (22, 23) und der Quersteg (25) einerseits und der mittlere Schenkel (24) andererseits durch einen Schlitz (28) getrennt sind.

4. Lötvorrichtung nach den Ansprüchen 2 und 3, **dadurch gekennzeichnet,** daß der Schlitz (28) zum Lötsteg (21) des Flachlötbügels (20) hin verbreitert ausgebildet ist.

5. Lötvorrichtung nach Anspruch 3 oder 4, **gekennzeichnet durch** einen erodierten Schlitz (28).

6. Lötvorrichtung nach einem der vorhergehenden Ansprüche, **dadurch gekennzeichnet,** daß der Lötbügelhalter (30) aus einem Mittelteil (31) und einem ringförmig geschlossenen, elektrisch isoliert und formschlüssig auf dem Mittelteil (31) angeordneten Außenteil (32) besteht, wobei Quersteg (25) und mittlerer Schenkel (24) des Fachlötbügels (20) lösbar mit zugeordneten Kontaktflächen (320, 310) von Außenteil (32) und Mittelteil (31) verbunden sind.

7. Lötvorrichtung nach Anspruch 6, **dadurch gekennzeichnet,** daß Mittelteil (31) und Außenteil (32) zumindest im Bereich der Kontaktflächen (320, 310) die gleiche Außenkontur aufweisen.

8. Lötvorrichtung nach Anspruch 7, **gekennzeichnet durch** eine rechteckförmige oder quadratische Außenkontur.

9. Lötvorrichtung nach Anspruch 8, **gekennzeichnet durch** eine rechteckförmige oder quadratische Außenkontur des Mittelteils (31) und eine rechteckförmige oder quadratische Innenkontur des Außenteils (32) im Bereich des Formschlusses.

10. Lötvorrichtung nach einem der Ansprüche 6 bis 9, **dadurch gekennzeichnet,** daß Mittelteil (31) und Außenteil (32) durch einen isolierenden Zweikomponenten-Klebstoff (33) miteinander verbunden sind.

## Revendications

1. Dispositif de brasage comportant un support d'étriers de brasage et au moins un étrier de brasage plat fixé de façon interchangeable au support d'étriers de brasage, et dans lequel deux branches extérieur de l'étrier de brasage plat peuvent être raccordées à un pôle d'une source de courant et une branche médiane de l'étrier de brasage plat peut être raccordée à l'autre pôle de la source de courant, caractérisé par le fait que l'étrier de brasage plat (10 ; 20), qui est formé d'un seul tenant à partir d'une plaque plane, possède une forme fermée, en raison de la présence d'une barrette transversale (15 ; 25) qui s'étend entre les branches extérieures (12, 13 ; 22, 23).

2. Dispositif de brasage suivant la revendication 1, caractérisé par le fait que les deux branches extérieures (22, 23) et la branche médiane (24) possèdent une forme s'élargissant en direction de la barrette transversale (25).

3. Dispositif de brasage suivant la revendication 1 ou 2, caractérisé par le fait que les deux branches extérieures (22, 23) et la barrette transversale (25) d'une part et la branche médiane (24) d'autre part sont séparées par une fente (28).

4. Dispositif de brasage suivant les revendications 2 et 3, caractérisé par le fait que la fente (28) s'élargit en direction de la barrette de brasage (21) de l'étrier de brasage plat (20).

5. Dispositif de brasage suivant la revendication 3 ou 4, caractérisé par une fente érodée (28).

6. Dispositif de brasage suivant l'une des revendications précédentes, caractérisé par le fait que le support (30) de l'étrier de brasage est formé par une partie médiane (31) et une partie extérieure (32) fermée avec une forme d'anneau, isolée électriquement et montée, selon une liaison par formes complémentaires, sur la partie médiane (31), la barrette transversale (25) et la branche médiane (24) de l'étrier de brasage plat (20) étant réunies de façon détachable à des surfaces associées de contact (320, 310) de la partie extérieure (32) et de la partie médiane (31).

7. Dispositif de brasage suivant la revendication 6, caractérisé par le fait que la partie médiane (31) et la partie extérieure (32) possèdent le même contour extérieur, au moins dans la zone des surfaces de contact (320, 310).

8. Dispositif de brasage suivant la revendication 7, caractérisé par un contour extérieur rectangulaire ou carré.

9. Dispositif de brasage suivant la revendication 8, caractérisé par un contour extérieur rectangulaire ou carré de la partie médiane (31) et un contour intérieur rectangulaire ou carré de la partie extérieure (32) dans la zone de liaison par formes complémentaires.

10. Dispositif de brasage suivant l'une des revendications 6 à 9, caractérisé par le fait que la partie médiane (31) et la partie extérieure (32) sont reliées entre elles par une colle isolante (32) formée de deux constituants.

## Claims

1. Soldering device having a soldering-bow holder and at least one flat soldering bow interchangeably fastened to the soldering-bow holder, in which arrangement two outer legs of the flat soldering bow can be connected to one pole of a power source and a centre leg of the flat soldering bow can be connected to the other pole of the power source, characterised in that the flat soldering bow (10 ; 20) formed in one piece from a flat plate has a closed shape due to a transverse web (15 ; 25) extending between the outer legs (12, 13 ; 22, 23).

2. Soldering device according to Claim 1, characterised in that the two outer legs (22, 23) and the centre leg (24) are designed so as to be widened towards the transverse web (25).

3. Soldering device according to Claim 1 or 2, characterised in that the two outer legs (22, 23) and the transverse web (25) on the one hand and the centre leg (24) on the other hand are separated by a slit (28).

4. Soldering device according to Claims 2 and 3, characterised in that the slit (28) is designed so as to be widened towards the soldering web (21) of the flat soldering bow (20).

5. Soldering device according to Claim 3 or 4, characterised by an eroded slit (28).

6. Soldering device according to one of the preceding claims, characterised in that the soldering-bow holder (30) consists of a centre part (31) and an electrically insulated outer part (32) closed in an annular shape and arranged in a positive-locking manner on the centre part (31), the transverse web (25) and the centre leg (24) of the flat soldering bow (20) being detachably connected to allocated contact surfaces (320, 310) of outer part (32) and centre part (31).

7. Soldering device according to Claim 6, characterised in that centre part (31) and outer part (32) have the same outer contour at least in the area of the contact surfaces (320, 310).

8. Soldering device according to Claim 7, characterised by a rectangular or square outer contour.

9. Soldering device according to Claim 8, characterised by a rectangular or square outer contour of the centre part (31) and a rectangular or square inner contour of the outer part (32) in the area of the positive-locking connection.

10. Soldering device according to one of Claims 6 to 9, characterised in that centre part (31) and outer part (32) are connected to one another by an insulating two-component adhesive (33).

# FIG 1

# FIG 2

# FIG 3